## Europäisches Patentamt

## European Patent Office

## Office européen des brevets

(19)

(11) Veröffentlichungsnummer: **0 176 745 B1**

# EUROPÄISCHE PATENTSCHRIFT

(12)

(45) Veröffentlichungstag der Patentschrift:
**22.02.89**

(21) Anmeldenummer: **85110603.9**

(22) Anmeldetag: **23.08.85**

(51) Int. Cl.⁴: **G01B 15/00, G01R 31/28**

(54) **Vorrichtung und Verfahren zur Vermessung von Längen in einem Raster-Korpuskularmikroskop.**

(30) Priorität: **24.09.84 DE 3435037**

(43) Veröffentlichungstag der Anmeldung:
**09.04.86 Patentblatt 86/15**

(45) Bekanntmachung des Hinweises auf die Patenterteilung:
**22.02.89 Patentblatt 89/8**

(84) Benannte Vertragsstaaten:
**DE FR GB NL**

(56) Entgegenhaltungen:
**FR-A- 2 326 030**

**IBM TECHNICAL DISCLOSURE BULLETIN, Band 22, Nr. 1, Juni 1979, Seiten 104,105, New York, US; R.D. MOORE et al.: "Electron beam measurement with on-line calibration"**
**IBM TECHNICAL DISCLOSURE BULLETIN, Band 21, Nr. 1, Juni 1978, Seite 151, New York, US; D.E. DAVIS et al.: "E-beam line width and pattern location measurement tool"**
**IBM TECHNICAL DISCLOSURE BULLETIN, Band 24, Nr. 1A, Juni 1981, Seiten 331,332, New York, US; C.F. ALIOTTA et al.: "SEM magnification standard"**

(73) Patentinhaber: **Siemens Aktiengesellschaft Berlin und München, Wittelsbacherplatz 2, D-8000 München 2(DE)**

(72) Erfinder: **Lischke, Burkhard, Prof. Dr., In der Heuluss 13, D-8000 München 82(DE)**
Erfinder: **Frosien, Jürgen, Dr.-Ing., An der Ottosäule 18, D-8012 Ottobrunn(DE)**

## Beschreibung

Die Erfindung betrifft eine Vorrichtung und ein Verfahren zur Vermessung von Längen mit einem Raster-Korpuskularstrahl nach dem Oberbegriff des Anspruchs 1 bzw. nach dem Oberbegriff des Anspruchs 9.

Mit steigender Integration in der Mikroelektronik werden die Abmessungen der einzelnen Schaltungskomponenten ständig geringer. Die geometrischen Strukturabmessungen bestimmen dadurch in immer stärkerem Maße die elektrischen Eigenschaften der Schaltungen. Die Einhaltung and Überprüfung sehr enger Maßtoleranzen sind daher sowohl für die Entwicklung als auch für die Fertigung von integrierten Schaltungen eine notwendige Voraussetzung.

Unter dem Begriff 'Mikrometrologie" werden nun alle meßtechnischen Untersuchungsmethoden zusammengafaßt, mit denen es möglich ist, Maße und Formen dieser Mikrostrukturen zu erfassen und zu vermessen.

Bei metrologischen Untersuchungen an Halbleiterstrukturen handelt es sich sowohl von seiten der erforderlichen Meßgenauigkeit als auch vom Umfang der durchzuführenden Messungen her um eine sehr anspruchsvolle Aufgabenstellung.

In der Halbleitertechnologie existiert das Problem, relativ große Längen mit hoher Genauigkeit zu vermessen. Beispiele für dieses Meßproblem sind die Vermessung von Masken mit Durchmessern bis zu 5 Zoll (12,7 cm) , die Bestimmung des Waferverzuges während des Fertigungsprozesses sowie die Bestimmung der Verzeichnung von lithografischen Strukturerzeugungsgeräten. Nimmt man an, daß die Meßstrecke beispielsweise 100 mm beträgt und daß eine absolute Kantenlage-Genauigkeit von 0,1 μm notwendig ist, so wird von dem Meßverfahren eine relative Meßgenauigkeit von $10^{-6}$ gefordert.

Da das Gesichtsfeld sowohl von Licht- als auch von Rasterelektronenmikroskopen für die Längenmessung derart großer Strecken bei weitem nicht ausreichend ist, werden gegenwärtig diese Mikroskope mit laserstrahl-kontrollierten Objekttischen kombiniert siehe z.B. IBM Technical Disclosure Bulletin, Band 22, Nr. 1, Juni 1979, Seiten 104, 105, New York, US; R.D. Moore et al.: "Electron beam measurement with au-line calibration". In diesen Systemen wird unter mikroskopischer Betrachtung zunächst eine Kante (ein Ende) der zu vermessenden Strecke mit einer Markierung des Meßmikroskops zur Deckung gebracht. Danach wird der Objekttisch solange verschoben, bis die zweite Kante (das andere Ende) der zu vermessenden Strecke mit der Markierung des Meßmikroskops koinzidiert. Die hierfür notwendige Verfahrstrecke, die erforderlich gewesen ist, um die gesamte zu vermessende Strecke von einem Ende bis zum anderen Ende an der Markierung des Meßmikroskops vorbeizuschieben, wird mit einem Laser-Interferometer gemessen. Diese mit dem Laserinterferometer gemessene Verfahrstrecke, um die der Objekttisch dabei verschoben worden ist, entspricht der Länge der zu vermessenden Strecke.

Derartige Meßanordnungen, bei denen ein mit einem Laser- Interferometer gekoppelter Objekttisch vorhanden ist, existieren sowohl in der Kombination Lasertisch-Lichtmikroskop als auch in der Kombination Lasertisch-Raster-Elektronenmikroskop für die Längenmessung mit Submikrometer-Auflösung. Diese konventionellen Meßsysteme erfordern stets ein aufwendiges Laser-Interferometer zur Kontrolle des Objekttisches, das den Anschaffungspreis des Meßsystems erheblich verteuert.

Der vorliegenden Erfindung liegt die Aufgabe zugrunde, eine Vorrichtung und ein Verfahren der eingangs genannten Art anzugeben, mit denen eine einfach durchzuführende, aber dennoch genaue Messung für die Bestimmung großer Längen ermoglicht wird, und die mit einem einfachen Raster-Korpuskularmikroskop verwirklicht werden können, ohne daß hierzu aufwendige Zusatzeinrichtungen notwendig sind.

Diese Aufgabe wird erfindungsgemäß durch eine Vorrichtung nach dem Anspruch 1 und durch ein Verfahren nach dem Anspruch 9 gelöst. Ausgestaltungen und Vorteile der Erfindung sind in den Unteransprüchen, der Beschreibung und der Zeichnung dargestellt.

Wenn einzelne Strukturen mit hoher Genauigkeit vermessen werden sollen, sind Meßgeräte mit hoher örtlicher Auflösung erforderlich. Ein Raster-Elektronenmikroskop besitzt gegenüber einem Lichtmikroskop eine um mehr als 10fach höhere Auflösung. Mit einer Vorrichtung und mit einem Verfahren nach der Erfindung ist eine relative Meßgenauigkeit von $10^{-6}$ auch dann möglich, wenn die Meßstrecke eine absolute Länge von beispielsweise 100 mm aufweist. Damit kann bei einer Meßstrecke von beispielsweise 100 mm eine Kantenlage mit einer absoluten Kantenlage-Genauigkeit von 0,1 μm ermittelt werden.

Mit einer Vorrichtung und mit einem Verfahren nach der Erfindung können auch Strecken auf elektrisch isolierenden Objekten vermessen werden, sofern die Primärkorpuskel-Energie bestimmte Schwellwerte nicht überschreitet. Diese Schwellwerte hängen von der Materialzusammensetzung des zu vermessenden Objekts, von der Probenanordnung und von der Detektoranordnung ab. Bei üblichen Detektor- und Probenanordnungen und bei Verwendung eines Primärelektronenstrahls sollen bei folgenden Materialzusammensetzungen des Objekts folgende Schwellwerte von der Primärelektronen-Energie nicht überschritten werden:

– Wenn eine AZ 1470-Resiststruktur auf einer Siliziumdioxid-Unterlage vermessen werden soll, soll die Primärelektronen-Energie einen Wert von 0,9 keV nicht überschreiten.

– Soll eine AZ 1470-Resiststruktur auf einer Polysilizium-Unterlage als Objekt vermessen werden, so soll die Primärelektronen-Energie einen Wert von 1,1 keV nicht überschreiten.

– Soll eine PBS-Resiststruktur auf einer Chrom-Lithografiemaske vermessen werden, so soll die Primärelektronen-Energie einen Wert von 0,7 keV nicht überschreiten.

– Soll eine Längenmessung auf einer Chromstruktur auf einem Glassubstrat als Objekt vorgenommen werden, so soll die Primärelektronen-Energie einen Wert von 2,0 keV nicht überschreiten.

Eine Vorrichtung und ein Verfahren nach der Erfindung finden in vorteilhafter Weise in der Halbleitertechnologie Verwendung, wo Lithografiemasken und Halbleiterwafer vermessen werden müssen. Voraussetzung hierfür ist, daß eine probenspezifische Primärelektronen-Energie nicht überschritten wird. Diese Schwellenenergie liegt bei den in der Halbleitertechnologie verwendeten Werkstoffen überwiegend in einem Energiebereich unterhalb von 3 keV, so daß für metrologische Untersuchungen in der Halbleitertechnologie leistungsfähige Niederspannungs-Raster-Elektronenmikroskope erforderlich sind. Raster-Elektronenmikroskope mit einer Feldemissionskathode sind für einen solchen Verwendungszweck besonders geeignet.

Zur Steigerung der Meßgenauigkeit und als Vorbereitung für eine automatisierte Längenmessung ist eine Verbesserung des Signal-Rausch-Verhältnisses beim Meßsignal vorteilhaft. Dies gilt insbesondere für die Vermessung solcher Objekte, die eine Primärelektronen-Energie unterhalb von 1 keV erfordern. Für diese Zwecke ist eine digitale Verarbeitung der Meßsignale besonders geeignet, da das Signal-Rausch-Verhältnis so nachträglich und ohne Erhöhung der Bestrahlungsdosis verbessert werden kann.

Bei der Vermessung von Mikrostrukturen ist bei einem lichtoptischen Meßverfahren eine Zuordnung der jeweiligen Kantenlage im Intensitätsprofil des Meßsignals in einfacher Weise nicht möglich. Bei lichtoptischen Meßverfahren hängt das Ergebnis einer Längenmessung von der willkürlichen Festlegung einer Intensitätsschwelle im Meßsignal ab. Lichtoptische Strukturbreiten-Meßgeräte können aus diesem Grund für eine absolute Vermessung feiner Strukturen nicht mehr ohne weiteres eingesetzt werden. Erfolgt dagegen eine Strukturbreitenmessung mittels einer Linienabtastung (line scan) in einem Raster-Elektronenmikroskop, so ist damit eine wesentliche Verbesserung der Meßgenauigkeit erreichbar. Das Linienabtast-Signal weist bei der Vermessung von feinen Strukturen wesentlich steilere Flanken auf, die mit der jeweiligen Kantenlage koinzidieren, als sie im Meßsignal eines lichtoptischen Verfahrens erzielt werden. Mit einem Raster-Elektronenmikroskop ist dabei eine genaue Längenmessung möglich, da die Meßgröße (die Länge) nur noch geringfügig von der Schwellenlage im Meßsignal abhängt.

Die Erfindung stellt ein einfaches, aber dennoch genaues Meßverfahren für die Bestimmung großer Längen zur Verfügung das in jedes Raster-Korpuskularmikroskop implementiert werden kann, ohne daß hierzu aufwendige Zusatzeinrichtungen erforderlich sind.

Ausführungsbeispiele der Erfindung sind in der Zeichnung dargestellt und werden im folgenden näher beschrieben.

Fig. 1 zeigt eine Vorrichtung nach der Erfindung.

Fig. 2 und 3 erläutern das Messen von kurzen Längen.

Fig. 4 erläutert ein Verfahren nach der Erfindung.

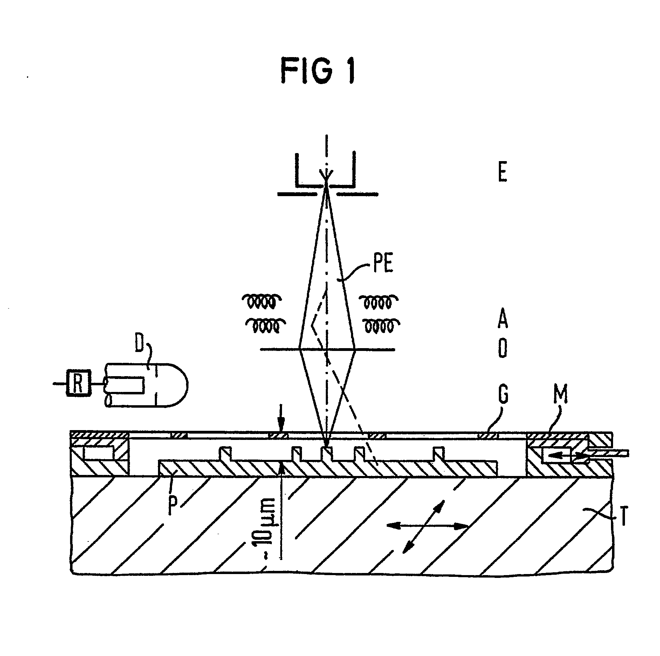

Fig. 1 zeigt eine Vorrichtung, die im wesentlichen aus einem normalen Raster-Elektronenmikroskop besteht, auf dessen Probentisch T jedoch ein zweiter Tisch (Meßtisch) M aufgesetzt ist. Dieser Tisch M trägt eine großflächige, geeichte Gittermaske G, die das gesamte zu vermessende Substrat P überdeckt, und die im Abstand von einigen μm, beispielsweise im Abstand von etwa 10 μm, über dem zu vermessenden Substrat P angebracht ist. Diese Gittermaske G, die zuvor laserinterferometrisch vermessen werden muß, stellt nun einen Kalibrierungsmaßstab dar, der aufgrund der hohen Schärfentiefe Δz gemeinsam mit dem Substrat P scharf abgebildet wird. Bei einer raster-elektronenmikroskopischen Abbildung beträgt die Schärfentiefe Δz etwa 10 μm bei einem Auflösungsverlust von 0,1 μm.

Mit der Einführung des geeichten Meßgitters G in ein Raster- Elektronenmikroskop kann eine Längenmessung in einfacher Weise durchgeführt werden. Das geeichte Meßgitter G kann beispielsweise eine Gitterkonstante von 10 μm und beispielsweise eine Stegbreite der Gitterstege von 1 μm aufweisen. Zu vermessende Längen, die kleiner als die Gitteröffnung des Meßgitters G sind, können direkt aus einer raster-elektronenmikroskopischen Abbildung bestimmt werden, da die Gitteröffnung der Gittermaske G den Eichmaßstab dafür liefert und da die Linearität der raster-elektronenmikroskopischen Abbildung im Bereich einer Gitteröffnung des Meßgitters G, die beispielsweise eine Länge und eine Breite von jeweils 9 μm aufweist, ausreichend ist.

Das Raster-Elektronenmikroskop besitzt eine Elektronenquelle E, die Primärelektronen PE emittiert. Diese Primärelektronen PE können mit Hilfe eines Ablenksystems A in zwei Dimensionen abgelenkt werden. Damit kann ein Teilbereich des Substrats P, beispielsweise über eine oder mehrere Gitteröffnungen des Meßgitters G hinweg, abgerastert werden. Mit Hilfe des Ablenksystems A können Längen, die kleiner als eine Gitteröffnung oder kleiner als einige Gitteröffnungen des Meßgitters G sind, direkt aus der raster-elektronenmikroskopischen Abbildung bestimmt werden, wobei die Gittermaske G den dazu erforderlichen Eichmaßstab liefert. Die Primärelektronen PE werden mit Hilfe des Objektivs O auf einen Punkt des Substrats P fokussiert. Neben dem Objektiv O können auch mehrere Linsen verwendet werden. Beim Auftreffen der Primärelektronen PE auf das Substrat P werden Sekundärelektronen ausgelöst, die in einem Sekundärelektronen-Detektor D nachgewiesen werden und so das Meßsignal liefern.

Eine Vorrichtung nach der Erfindung kann beispielsweise durch Modifikation eines Raster-Elektronenmikroskops hergestellt werden, wie es in der US-Patentschrift 4 223 220 beschrieben ist.

Der Probentisch T ist in zwei Dimensionen, nämlich in der x-Richtung und in der y-Richtung, verschiebbar. Der Meßtisch M kann relativ zum Probentisch T verschoben werden, so daß die gesamte Oberfläche des Substrats P für eine Messung mit dem Strahl der Primärelektronen PE zugänglich ist, insbesondere auch solche Bereiche auf der Oberfläche des Substrats P, die bei einer bestimmten Relativlage der Gittermaske G bezüglich des Substrats P für den Strahl der Primärelektronen PE von einem Gittersteg der Gittermaske G verdeckt sind.

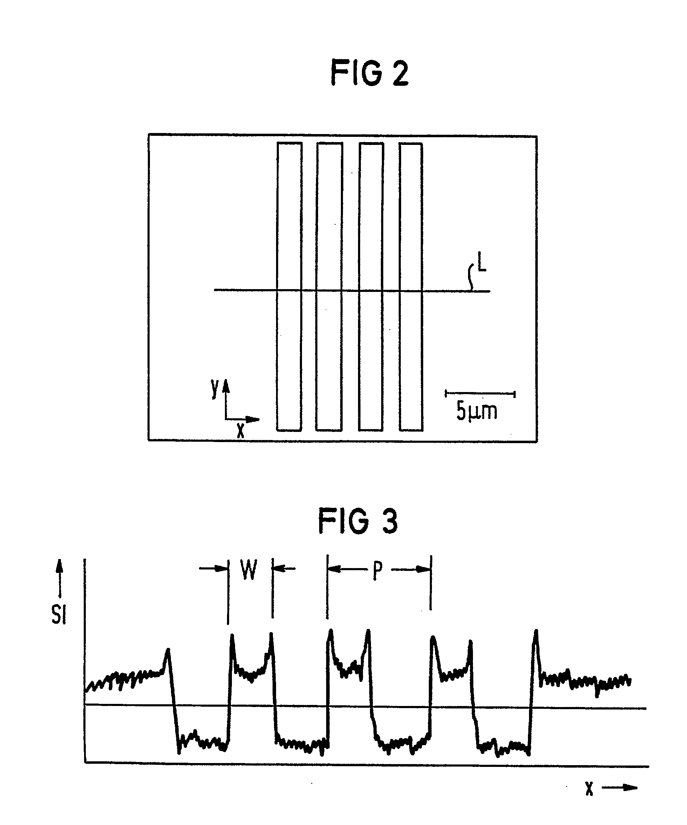

Fig. 2 und 3 erläutern das Messen von kurzen Längen. Fig. 2 zeigt ein raster-elektronenmikroskopisches Bild beispielsweise einer Gitteröffnung, das mit einem Raster-Elektronenmikroskop nach Fig. 1 aufgenommen worden ist. Dieses zweidimensionale Bild nach Fig. 2 zeigt einen Ausschnitt aus einer Chrommaske, die scharfkantige Strukturdetails aufweist. Diese scharfkantigen Strukturdetails besitzen eine Periodizität P von 3 μm und eine Strukturbreite w. Wenn die Struktur nach Fig. 2 entlang der Linie L in Richtung der x-Achse mit dem Raster-Elektronenstrahl abgetastet wird, so erhält man ein Sekundärelektronen-Meßsignal SI, wie es in Fig. 3 als Funktion des Ortes x dargestellt ist. Das Signal SI besitzt so steile Flanken, daß es ohne Schwierigkeiten in geeigneter Weise für eine Auswertung durch einen Rechner aufbereitet werden kann. Zu diesem Zweck kann beispielsweise in der Signalverarbeitungskette hinter dem Sekundärelektronen-Detektor D ein Bewerter angeordnet werden, der einen oder mehrere Schwellwerte zur Bewertung des Signals SI aufweist. Als Bewerter kommt dafür beispielsweise eine Schmitt-Trigger-Schaltung in Frage.

Eine Kantenlage innerhalb einer Gitteröffnung muß nicht unbedingt durch Linienabtastung ermittelt werden. Beispielsweise kann das raster-elektronenmikroskopisch aufgenommene Bild einer Gitteröffnung – wie beispielsweise das Bild nach Fig. 2 – zur Steigerung der Meßgenauigkeit und als Vorbereitung für eine automatisierte Längenmessung mit einem digitalen Bildspeicher R und Bildverarbeitungssystem weiterverarbeitet werden. Dadurch kann das Signal-Rausch-Verhältnis nachträglich und ohne Erhöhung der Bestrahlungsdosis des Substrats P verbessert werden. Auf das Sekundärelektronen-Bild nach Fig. 2 kann dann beispielsweise ein Tiefpaßfilter angewendet werden, das lediglich in Strukturrichtung wirksam ist. Diese Filterung entspricht in ihrer Wirkung damit einer lichtoptischen Spaltabtastung, wobei die Länge eines solchen bei einer lichtoptischen Spaltabtastung verwendeten Spaltes durch die Reichweite des Tiefpaßfilters nachgeahmt werden kann. Hierdurch entsteht ein Bild, das in seinem Intensitätsverlauf leicht und genau auswertbar ist, und das auch einem Rechner für eine automatisierte Linienbreitenmessung zugeführt werden kann. Die Strukturkanten einer Struktur nach Fig. 2 werden durch Gradientenbildung und Diskriminierung isoliert. Der Rechner ist dann in der Lage, anhand dieses Binärbildes eine Länge innerhalb eines wählbaren Meßrahmens zu ermitteln. Auf diese Weise kann beispielsweise ein Mittelwert für den Abstand einer Kante zu einem Gittersteg der Gittermaske G ermittelt werden.

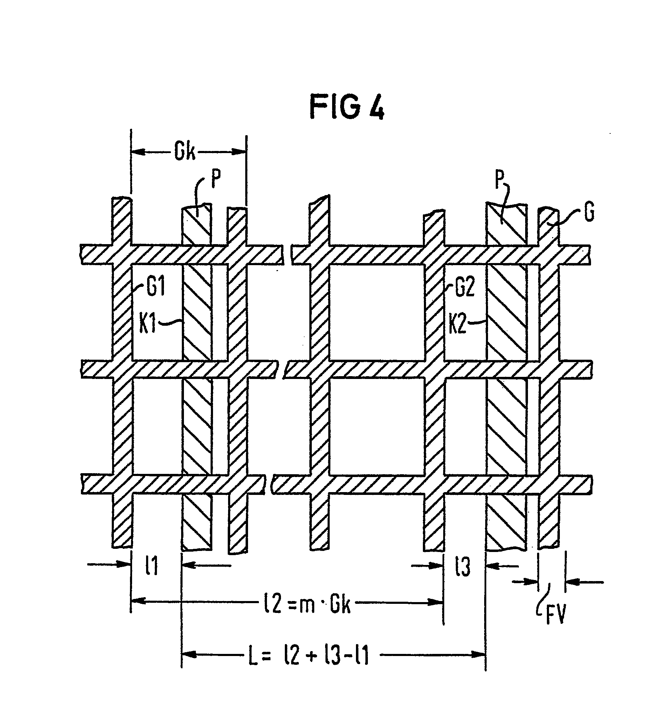

Fig. 4 erläutert ein Verfahren nach der Erfindung. Zur Vermessung von Längen, die sich über viele Gittermaschen hinweg erstrecken, muß der Probentisch T verschoben werden. Dabei wird von der Justierung des Probentisches T keine hohe Genauigkeit verlangt. Die Messung setzt sich dann aus drei Abschnitten zusammen. Zuerst wird der

Abstand l1 einer Meßkante K1 zu einem benachbarten Gittersteg G1 ermittelt. Sodann wird der Probentisch T solange verschoben, bis die Meßkante K2 ins Gesichtsfeld des Raster-Elektronenmikroskops kommt, wobei während der Verschiebung des Probentisches T die Anzahl m der durch das Gesichtsfeld des Raster-Elektronenmikroskops hindurchgeschobenen Gitterperioden ermittelt wird. Schließlich wird der Abstand l3 von einer zweiten Meßkante K2 zu einem benachbarten Gitterrand G2 ermittelt. Der Abstand L zwischen den beiden Meßkanten K1 und K2 ergibt sich als Summe bzw. Differenz aus den Längen L1, L2 = m·Gk und l3. Im Beispiel nach Fig. 4 ergibt sich der Abstand L zwischen den beiden Meßkanten K1 und K2 als Summe aus den Längen l2 und l3, von denen die Länge l1 abgezogen wird. Werden innerhalb der Gitteröffnungen Abstände zwischen den Meßkanten K1, K2 zu anderen Gitterrändern als zu G1, G2 gemessen, so sind diese anderen Abstände mit der entsprechenden Anzahl der Gitterkonstanten Gk zum Gesamtabstand L zu kombinieren. Die Längen l1, l3 können nach einem Verfahren bestimmt werden, wie sie anhand der Fig. 2 und 3 beschrieben worden sind.

Wenn der Meßtisch M eine geeichte Feinverschiebung FV gegenüber dem Probentisch T hat, können auch Strukturen auf dem Substrat P erfaßt werden, die sonst unter einem Gittersteg der Gittermaske G liegen würden. Die Feinverschiebung FV soll etwas größer als die Breite eines Gitterstegs sein und kann beispielsweise mittels eines Piezoantriebs erfolgen. Diese Feinverschiebung FV muß bei der Ermittlung des Gesamtabstands L zwischen den beiden Meßkanten K1, K2 in entsprechender Weise berücksichtigt werden.

Die bisher beschriebene Längenmessung mit Hilfe der Gittermaske G läßt sich leicht automatisieren, da hierfür Positionierverfahren aus der Elektronenlithografie übernommen werden können. Für eine Abstandsbestimmung einer Meßkante von einer benachbarten Gitterkante kann z.B. eine digitale Linienabtastung (line scan) mit bekannter Schrittweite (S. Miyauchi et al, IEEE Transactions on Electron Devices, Vol. ED-17, No.6, Juni 1970) oder das Verfahren der "Scan Inversion" (US-Patentschrift 4 219 719) verwendet werden. Bei letzterem Verfahren wird eine Gitteröffnung, die die Meßkante enthält, entlang einer Zeile in beiden Richtungen mit gleicher Geschwindigkeit abgetastet. Dabei wird bei einer digitalen Abtastung während des Hinlaufes vom Beginn der Zeile bis zum Erreichen der Meßkante eine erste Schrittzahl festgestellt und wird während des Rücklaufes vom Ende der Zeile bis zur Meßkante eine zweite Schrittzahl ermittelt. Nach einem Durchlauf ergibt sich der Abstand der Meßkante von einer Gitterkante aus der Differenz von erster und zweiter Schrittzahl.

Die Zählung der Gitterperioden des Meßgitters G während der Grobverschiebung des Probentisches T kann aus dem Sekundärelektronen-Signal SI bei abgeschalteter Rasterung des Strahls der Primärelektronen PE erfolgen, da die Grobverschiebung einer mechanischen Linienabtastung (line scan) entspricht, in deren Signalverlauf sich die Gitterstege deutlich abheben.

Zur Steigerung des Sekundärelektronen-Signals und damit zur Steigerung der Meßgenauigkeit kann das Meßgitter G mit einem elektrischen Potential beaufschlagt werden. Bei Verwendung von Elektronenstrahlen sind dabei positive Gitterspannungen vorteilhaft, da diese positiven Gitterspannungen die von dem Substrat P startenden Sekundärelektronen absaugen und zum Detektor D hin beschleunigen.

Ein oberhalb des Substrats P auf definiertem elektrischen Potential liegendes Gitter G ist auch unter einem weiteren Aspekt vorteilhaft. Bei elektrisch isolierenden Substraten P können sich Aufladungen und daraus resultierende elektrische Felder, die bei der Elektronenbestrahlung entstehen, nicht so weit in den Raum oberhalb des Substrats P auswirken und können daher dort auch den Strahl der Primärelektronen PE nicht so sehr beeinflussen. Aufladungsbedingte Verzeichnungen der Abbildung sind daher weitgehend vermieden, was der Meßgenauigkeit zugute kommt.

Die angegebenen Abmessungen für die Gittermaske G sind keineswegs bindend. Diese Abmessungen des Meßgitters G sind vielmehr dem Meßproblem und den zu vermessenden Strukturen anzupassen. Geeignet für ein Meßgitter G sind Gittermasken, wie sie für die Elektronenprojektion verwendet werden. Aber auch andere Masken, z.B. Masken mit definierten Löchern, sind als Meßgitter G denkbar. Die Erfindung ist nicht allein auf die Verwendung von Elektronenstrahlen beschränkt. Eine Vorrichtung und ein Verfahren nach der Erfindung sind auf alle Strahlungen und Anordnungen übertragbar, bei denen eine ausreichende Auflösung und eine ausreichende Schärfentiefe vorliegen.

## Patentansprüche

1. Vorrichtung zur Vermessung von Längen (L) mit einem Rastermikroskop zur Erzeugung eines Korpuskularstrahles (PE) und mit einem Probentisch (T), auf dem ein Objekt (P) angeordnet ist, dadurch gekennzeichnet,
   – daß auf dem Probentisch (T) ein zweiter Tisch (M) aufgesetzt ist, der eine geeichte Gitterstruktur (G) trägt, die den zu vermessenden Bereich des Objekts (P) überdeckt, und
   – daß die Gitterstruktur (G) einen Abstand vom Objekt (P) aufweist, der kleiner oder gleich der Schärfentiefe der Vorrichtung ist.

2. Vorrichtung nach Anspruch 1, dadurch gekennzeichnet, daß die Gitterstruktur (G) laserinterferometrisch vermessen ist.

3. Vorrichtung nach Anspruch 1 oder 2, dadurch gekennzeichnet, daß die Gitterstruktur (G) eine Gitterkonstante (Gk) von etwa 10 µm aufweist.

4. Vorrichtung nach einem der Ansprüche 1 bis 3, gekennzeichnet durch eine Einrichtung (M) zur geeichten Feinverschiebung der Gitterstruktur (G) bezüglich des Probentisches (T).

5. Vorrichtung nach einem der Ansprüche 1 bis 4, dadurch gekennzeichnet, daß die Energie des Korpuskularstrahls (PE) so gewählt ist, daß das Objekt (P) nicht elektrisch aufgeladen wird.

6. Vorrichtung nach einem der Ansprüche 1 bis 5, gekennzeichnet durch eine Einrichtung (R) zur digitalen Verarbeitung des Meßsignals.

7. Vorrichtung nach einem der Ansprüche 1 bis 6, gekennzeichnet durch eine Gittermaske als Gitterstruktur (G).

8. Vorrichtung nach einem der Ansprüche 1 bis 6, gekennzeichnet durch eine Maske mit definierten Löchern als Gitterstruktur (G).

9. Verfahren zur Vermessung von Längen (L) mit einem Rastermikroskop, wobei ein auf einem Probentisch (T) befindliches Objekt (P) mit einem Korpuskularstrahl (PE) abgetastet wird, dadurch gekennzeichnet – daß auf dem Probentisch (T) ein zweiter, eine Gitterstruktur (G) tragender Tisch (M) aufgesetzt wird, und
   – daß diese Gitterstruktur (G) gemeinsam mit dem zu vermessenden Bereich des Objekts (P) scharf abgebildet wird,.

10. Verfahren nach Anspruch 9, dadurch gekennzeichnet, daß Längen (l1, l3), die kleiner als ein Gitterabstand sind, direkt aus der Abbildung bestimmt werden.

11. Verfahren nach Anspruch 9 oder 10, dadurch gekennzeichnet,
   – daß zur Vermessung von Längen (L), die sich über mehr als einen Gitterabstand (Gk) erstrecken, der Probentisch (T) verschoben wird,
   – daß der Abstand (l1) einer ersten Meßkante (K1) zu einem dieser ersten Meßkante (K1) benachbarten Gitterrand (G1) ermittelt wird,
   – daß der Abstand (l3) einer zweiten Meßkante (K2) zu einem dieser zweiten Meßkante (K2) benachbarten Gitterrand (G2) ermittelt wird,
   – daß der Abstand (l2) zwischen den beiden genannten Gitterrändern (G1, G2) als Funktion der Anzahl (m) von Gitterabständen (Gk), die zwischen den beiden genannten Gitterrändern (G1, G2) liegen, ermittelt wird, und
   – daß schließlich aus den drei gemessenen Abständen (l1, l2, l3) der Abstand (L) zwischen der ersten und der zweiten Meßkante (K1, K2) ermittelt wird.

12. Verfahren nach einem der Ansprüche 9 bis 11, dadurch gekennzeichnet, daß zur Erfassung einer Meßkante, die unter einem Gittersteg liegt, die Gitterstruktur feinverschoben wird und daß das Ausmaß dieser Feinverschiebung (FV) bei der Ermittlung der Länge berücksichtigt wird.

13. Verfahren nach einem der Ansprüche 9 bis 12, dadurch gekennzeichnet, daß der Abstand einer Meßkante (K1, K2) von einem Gitterrand (G1, G2) über eine digitale Linienabtastung) mit bekannter Schrittweite ermittelt wird.

14. Verfahren nach einem der Ansprüche 9 bis 13, dadurch gekennzeichnet, daß zur Ermittlung des Abstands (l2) zwischen zwei Gitterrändern (G1, G2) die Rasterung des Korpuskularstrahls (PE) abgeschaltet wird.

15. Verfahren nach einem der Ansprüche 9 bis 14, dadurch gekennzeichnet, daß zur Verbesserung des Meßsignals die Gitterstruktur (G) mit einem elektrischen Potential beaufschlagt wird.

16. Verfahren nach einem der Ansprüche 9 bis 15, dadurch gekennzeichnet, daß die Meßsignale digitalisiert werden.

## Claims

1. Device to measure lengths (L) using a scanning microscope for producing a corpuscular beam (PE) and having a sample table (T) on which an object (P) is arranged, characterized in that on the sample table (T) a second table (M) is placed which bears a calibrated grid structure (G) covering the area of the object (P) to be measured, and in that the grid structure (G) is at a distance from the object (P) which is smaller than or equal to the depth of focus of the device.

2. Device according to Claim 1, characterized in that the grid structure (G) is measured by means of laser-interferometry.

3. Device according to Claim 1 or 2, characterized in that the grid structure (G) has a grid constant (Gk) of about 10 μm.

4. Device according to one of Claims 1 to 3, characterized by a facility (M) for the calibrated fine displacement of the grid structure (G) with respect to the sample table (T).

5. Device according to one of Claims 1 to 4, characterized in that the energy of the corpuscular beam (PE) is selected so that the object (P) is not electrically charged.

6. Device according to one of Claims 1 to 5, characterized by a facility (R) for digitally processing the measurement signal.

7. Device according to one of Claims 1 to 6, characterized by a grid mask as the grid structure (G).

8. Device according to one of Claims 1 to 6, characterized by a mask with defined holes as the grid structure (G).

9. Method to measure lengths (L) using a scanning microscope, an object (P) located on a sample table (T) being scanned by a corpuscular beam (PE), characterized in that on the sample table (T) a second table (M) bearing a grid structure (G) is placed, and in that this grid structure (G) is imaged sharply together with the area of the object (P) to be measured.

10. Method according to Claim 9, characterized in that lengths (l1, l3) which are smaller than one grid spacing are directly determined from the image.

11. Method according to Claim 9 or 10, characterized in that to measure lengths (L) extending over more than one grid spacing (Gk) the sample table (T) is displaced, in that the distance (l1) of a first measuring edge (K1) to a grid edge (G1) adjacent to this first measuring edge (K1) is determined, in that the distance (l3) of a second measuring edge (K2) to a grid edge (G2) adjacent to this second measuring edge (K2) is determined, in that the distance (l2) between the two said grid edges (G1, G2) is determined as a function of the number (m) of grid spacings (Gk) lying between the two said grid edges (G1, G2), and in that finally, from the three measured distances (l1, l2, l3), the distance (L) between the first and the second measuring edge (K1, K2) is determined.

12. Method according to one of Claims 9 to 11, characterized in that, for recording a measuring edge lying under a grid crosspiece, the grid structure is finely displaced and in that the extent of this fine displacement (FV) is taken into account when determining the length.

13. Method according to one of Claims 9 to 12, characterized in that the distance of a measuring edge (K1, K2) from a grid edge (G1, G2) is determied by means of a digital line scan with known step interval.

14. Method according to one of Claims 9 to 13, characterized in that the scanning of the corpuscular beam (PE) is switched off for determining the distance (l2) between two grid edges (G1, G2).

15. Method according to one of Claims 9 to 14, characterized in that an electrical potential is applied to the grid structure (G) to improve the measurement signal.

16. Method accordintg to one of Claims 9 to 15, characterized in that the measurement signals are digitized.

## Revendications

1. Dispositif pour mesurer des longueurs (L) à l'aide d'un microscope à balayage pour produire un faisceau corpusculaire (PE) et comportant une table porte-échantillon (T), sur laquelle est disposé un objet (P), caractérisé par le fait que sur la table porte-échantillon (T) se trouve disposée une seconde table (M), qui porte une structure en forme de grille étalonnée (G) qui recouvre la zone à mesurer de l'objet (P), et que la structure en forme de grille (G) est à une distance de l'objet (P), inférieure ou égale à la profongeur de champ du dispositif.

2. Dispositif suivant la revendication 1, caractérisé par le fait que la structure en forme de grille (G) est mesurée par un interféromètre à laser.

3. Dispositif selon la revendication 1 ou 2, caractérisé par le fait que la structure en forme de grille (G) possède une constante (Gk) égale à environ 10 μm.

4. Dispositif selon l'une des revendications 1 à 3, caractérisé par un dispositif (M) servant à réaliser un déplacement précis étalonné de la structure en forme de grille (G) par rapport à la table porte-échantillon (T).

5. Dispositif suivant l'une des revendications 1 à 4, caractérisé par le fait que l'énergie du faisceau corpusculaire (PE) est choisie de manière que l'objet (P) ne soit pas chargé électriquement.

6. Dispositif suivant l'une des revendications 1 à 5, caractérisé par un dispositif (R) servant à réaliser le traitement numérique du signal de mesure.

7. Dispositif suivant l'une des revendications 1 à 6, caractérisé par un masque en forme de grille constituant la structure en forme de grille (G).

8. Dispositif suivant l'une des revendications 1 à 6, caractérisé par un masque comportant des trous définis, en tant que structure en forme de grille (G).

9. Procédé pour mesurer les longueurs à l'aide d'un microscope à balayage, selon lequel on explore par balayage, au moyen d'un faisceau corpusculaire (PE), un objet (P) situé sur une table porte-échantillon (T), caractérisé par le fait
— qu'on dispose sur la table porte-échantillon (T) une seconde table (M) portant une structure en for-

11       **EP 0 176 745 B1**

me de grille (G), et

– qu'on forme une image nette de cette structure en forme de grille (G) ainsi que de la zone à mesurer de l'objet (P).

10. Procédé selon la revendication 9, caractérisé en ce qu'on détermine des longueurs (l1, l3), qui sont inférieures à un intervalle de la grille, directement à partir de l'image formée.

11. Procédé suivant la revendication 9 ou 10, caractérisé par le fait

– que pour mesurer des longueurs (L) qui s'étendent sur une distance supérieure à un intervalle (Gk) de la grille, on déplace la table porte-échantillon (T),

– qu'on détermine la distance (l1) entre un bord de mesure (K1) et un bord (G1) de la grille, voisin de ce premier bord de mesure (K1),

– qu'on détermine la distance (l3) entre un second bord de mesure (K2) et un bord (G2) de la grille voisin de ce second bord de mesure (K2),

– qu'on détermine la distance (l2) entre les deux bords indiqués (G1, G2) de la grille en fonction du nombre (m) d'intervalles (Gk) de la grille, qui sont situés entre les deux bords indiqués (G1, G2) de la grille, et

– qu'on détermine enfin, à partir des trois distances mesurées (l1, l2, l3), la distance (L) entre les premier et second bords de mesure (K1, K2).

12. Procédé suivant l'une des revendications 9 à 11, caractérisé par le fait que pour détecter un bord de mesure situé au-dessous d'un barreau de la grille, on déplace finement la structure en forme de grille et qu'on tient compte de la valeur de ce décalage fin (FV) lors de la détermination de la longueur.

13. Procédé suivant l'une des revendications 9 à 12, caractérisé par le fait qu'on détermine la distance entre un bord de mesure (K1, K2) et un bord (G1, G2) de la grille au moyen d'une exploration par balayage linéaire numérique avec un pas d'avance connu.

14. Procédé suivant l'une des revendications 9 à 13, caractérisé par le fait que pour déterminer la distance (l2) entre des bords (G1, G2) de la grille, on interrompt le balayage de trame du faisceau corpusulaire (PE).

15. Procédé suivant l'une des revendications 9 à 14, caractérisé par le fait que pour améliorer le signal de mesure, on charge la structure en forme de grille (G) avec un potentiel électrique.

16. Procédé suivant l'une des revendications 9 à 15, caractérisé par le fait qu'on numérise les signaux de mesure.

7

# FIG 1

# FIG 2

# FIG 3

# FIG 4